# EUROPEAN PATENT APPLICATION

(11) **EP 1 271 156 A2**
(43) Date of publication of application: **02.01.2003**
(21) Application number: 02077513.6
(22) Date of filing: 25.06.2002
(51) Int. Cl.: G01R 1/04

(54) **Test/burn in socket assembly**

(30) Priority: 25.06.2001 US 300871 P
(71) Applicant: Xpeqt AG, 3980-Tessenderlo (BE)
(72) Inventor: Dreesen,Raf, 3600 Genk (BE); Croes,Kristof, 3590 Diepenbeek (BE)
(74) Representative: Wilson Gunn Skerrett

(57) **Abstract**

Improved socket assembly structures that reduce the thermally induced stresses on socket assemblies by a novel combination of socket frame structures, materials and methods of connecting the ceramic slabs, that receive a packaged integrated circuit, with the frame structures, where the socket assembly includes an upper slab mounted on a frame structure and where the upper slab is connected with the frame structure along only one edge of the slab, thus allowing a relative movement between the slab and the frame structure at least in a direction generally perpendicular to the one edge, the slab having a plurality of pin holes to receive the leads of an electronic package. Furthermore, certain embodiments of the present invention provide a stiffener that is attached to the underside of the circuit board to help reduce the thermally induced deflection of the circuit board during elevated temperature testing.

## Description

### CROSS-REFERENCES TO RELATED APPLICATIONS

This application claims the benefit of U.S. Provisional Patent Application No. 60/300,871, entitled: "Socket Assembly Construction," filed June 25, 2001, the disclosure of which is hereby incorporated by reference in its entirety for all purposes.

### BACKGROUND OF THE INVENTION

The present invention relates in general to socket assemblies for use in the field of microelectronics, and in particular to socket assemblies used during the testing or burn-in of packaged microelectronic components or systems. The testing of microelectronic packages typically includes testing at elevated temperatures in the ranges between room temperature and approximately 450 °C. In addition to being subjected to such elevated temperature testing or burn-in tests, the socket assemblies also need to withstand the temperature cycling tests that a microelectronic package experiences. During temperature cycling tests, a microelectronic package and hence its socket assembly are subjected to temperature cycling between approximately -135°C and +85°C.

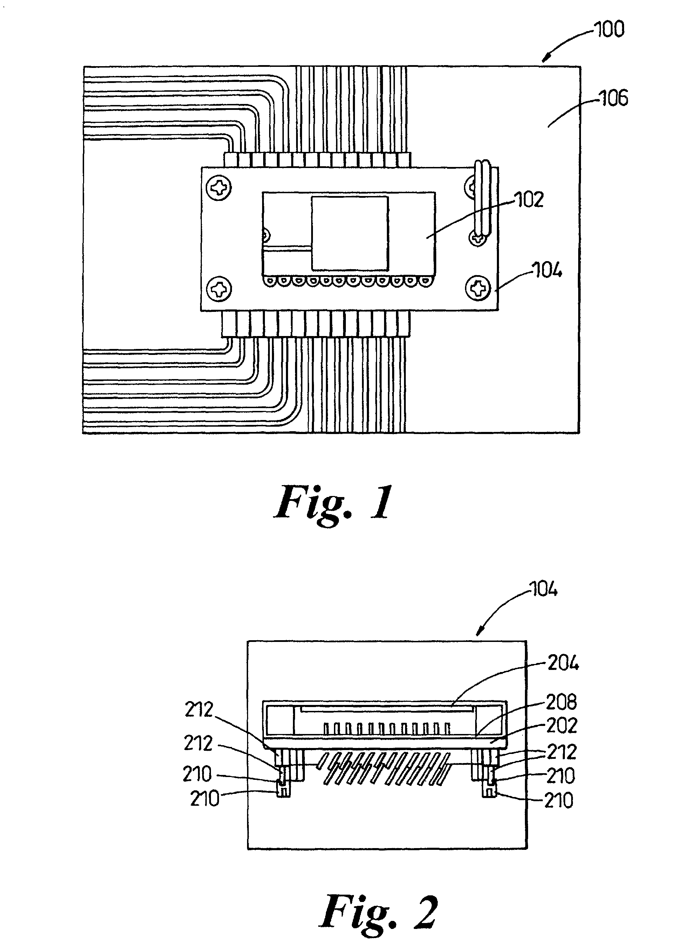

A problem associated with such testing is related to the high temperature environments maintained during testing that can subject the socket assembly and the electronic package to excessive temperature induced mechanical stresses. Fig. 1 shows a typical set up used for the high temperature testing of an electronic package. Fig. 1 shows a common package-socket-burn-in board configuration 100. As is shown in Fig. 1 an electronic package 102 is mounted on a socket 104, with the socket 104 connecting the package 102 with the printed circuit or burn-in-board 106. Such a socket is typically soldered or screwed on a burn-in board, and the burn-in board is connected to the outside of an oven (not shown), in which the electronic package, the socket, and the burn-in board are placed for high temperature, burn-in or cyclic testing.

Fig. 2 is a side view of a common commercially available socket assembly 104, such as, for example, the one shown in Fig. 1. The socket assembly 104 includes two ceramic slabs 202, 204. The top slab 204 has several pin holes to receive the leads from an electronic package. Leads extending from the lower part of the socket enable the socket to make an electrical connection between a sample (e.g., electronic package) being tested and the circuit board. The upper 204 and lower 202 slabs are separated from one another by a frame structure 208. The slabs 202, 204 and the frame structure 208 have appropriate apertures (near the comers of the slab) to receive fasteners 210. The fasteners, in conjunction with the slabs and the frame structure create a multi-part socket, which is held in place on the circuit board using the same fasteners. The lower slab is maintained above the circuit board by the spacers 212 positioned on the fasteners below the lower slab 202.

A problem with such typical sockets as shown in Figs. 1 and 2 is that they are not very reliable when subjected to high temperature conditions. An example of the lack of the reliability of such sockets is that the ceramic slabs that make up part of the socket tend to break. The breaking of the ceramic slabs is believed to be due to the excessive thermal loading that the socket assembly experiences during elevated and cyclic temperature testing.

There is therefore a need to provide a socket assembly construction that reduces the thermal stresses and hence improves the reliability of the socket assemblies during elevated or cyclic temperature tests.

### BRIEF SUMMARY OF THE INVENTION

The present invention provides improved socket assembly structures that reduce the thermally induced stresses on socket assemblies by a novel combination of socket frame structures and methods of connecting the ceramic slabs with the frame structures. Furthermore, certain embodiments of the present invention provide a support element such as a stiffener that is attached to the underside of the circuit board to help reduce the thermally induced deflection of a circuit board during elevated temperature testing.

An embodiment of the present invention is directed to a socket assembly for connecting an electronic package having an array of leads extending from a bottom surface thereof to a circuit board for use during testing or burn-in, having a first slab configured to mounted above the circuit board, and when mounted above the circuit board, the first slab being supported and maintained above the circuit board by a plurality of spacer elements, the spacer elements mounted on fasteners mountable through apertures in the first slab; a frame structure mounted above the first slab, the frame structure having apertures configured to line up with matching apertures on the first slab; and a second slab mounted above the frame structure, the second slab having apertures located near its comers, where the apertures are configured to line up with matching apertures in the first slab, the second slab configured to be connected with the frame structure along only one edge of the second slab, thus allowing a relative movement between the second slab and the frame structure at least in a direction generally perpendicular to the one edge, the second slab having a plurality of pin holes to receive the leads of the electronic package, and the first slab providing for electrical connections between the electronic package and the circuit board.

Certain embodiments of the present invention further include a push plate configured to be mounted above the second slab and positioned above and parallel to the one edge; an upside down L-shaped fastener piece, the L-shaped fastener piece configured to fit over the push plate, such that one leg of the L-shaped fastener is connected with the circuit board via a fastener fitting through an aperture in the circuit board and a first aperture in the L-shaped fastener, and a second fastener fitting through a second aperture in the other leg of the L-shaped fastener, the second fastener is configured to engage the push plate, to impart a force pushing the socket assembly towards the circuit board.

Certain other embodiments of the present invention further include a support element or a stiffener configured to be mounted on the underside of the circuit board, the stiffener or support element generally mounted along a longitudinal axis parallel to a longitudinal axis of the socket assembly, thus reducing excessive thermally induced deflection of the circuit board during the testing of the electronic package.

Furthermore, in some embodiments of the present invention, the frame structure includes a substantially U-shaped open frame member; and a substantially flat frame end member configured to engage the substantially U-shaped structure, thus forming a combined two-piece substantially rectangular shaped frame structure.

These and other embodiments of the present invention, as well as its advantages and features, are described in more detail in conjunction with the description below and the attached figures.

### BRIEF DESCRIPTION OF THE DRAWINGS

Fig. 1 is a top view of a typical prior art package-socket-burn-in board set up.
Fig. 2 is a side view of a commercially available prior art socket.
Fig. 3A is a top view of a first portion of a 2-piece socket assembly frame construction according to an embodiment of the present invention.
Fig. 3B is top view of a second portion of a 2-piece socket assembly frame construction according to an embodiment of the present invention.
Fig. 3C is a top view of the 2-piece socket assembly frame construction according to an embodiment of the present invention.
Fig. 3D is a top view of a socket assembly using the frame structures of Figs. 3A-3C.
Fig. 4 illustrates portions of an alternate embodiment of a socket assembly frame construction in accordance with the present invention.
Fig. 5A is a top view of the complete socket-frame assembly using the portions of frame construction of Fig. 4.
Fig. 5B is a side view at the top of a burn-in board of the socket assembly of Fig. 5A.
Fig. 5C is bottom view of the socket assembly of Fig. 5A.
Fig. 5D is a side view of the socket assembly showing the stiffener of Fig. 4 and Fig. 5C.

### DETAILED DESCRIPTION OF THE INVENTION

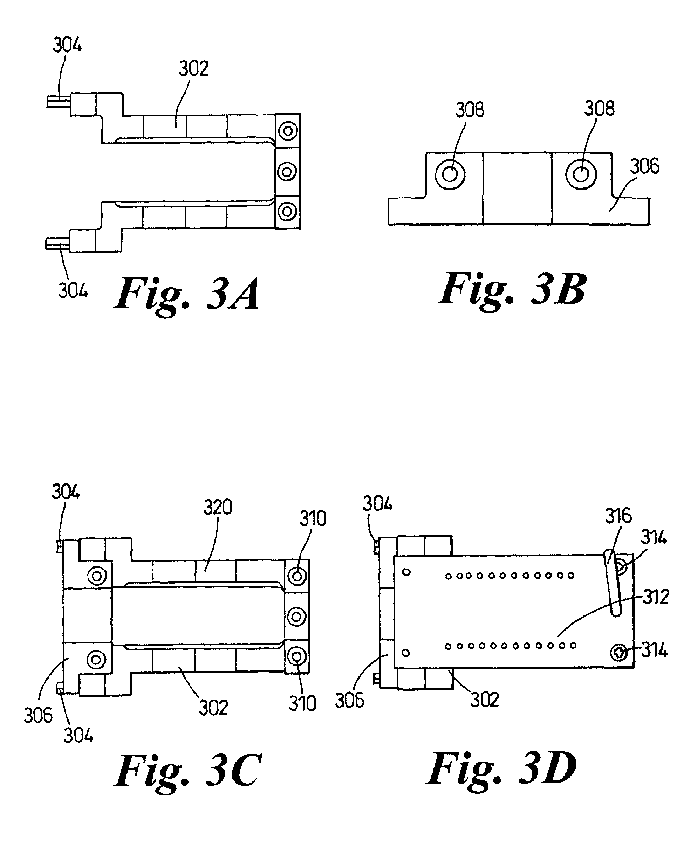

Figures 3A-3C illustrate portions of an embodiment of an improved frame construction for use in a socket assembly configured to reduce the stresses on the socket (i.e. upper slab). As is shown in Fig. 3C, the frame structure 320 includes a first U-shaped portion 302 and a second frame end portion 306. Referring to Figs. 3A and 3B, pins 304 in the first portion 302 mate with holes 308 in the frame end portion 306, thus forming the combined frame 320 (shown in Fig. 3C). The 2-piece frame is preferably made of a metallic material having a low coefficient of thermal expansion, such as, for example stainless steel. Other metal or non-metallic constructions are also suitable for portions 302 and 306 so long as the frame structure when connected with the upper slab, does not create excessive thermal stresses in the socket assembly during elevated or cyclic temperature testing. In preferred aspects, the material used for the frame structure should have a coefficient of thermal expansion of 10E-06 °C⁻¹ or lower, and more preferably lower than 9E-06 °C⁻¹. Furthermore, the thermal expansion coefficients of the slabs and the frame structure should preferably be within approximately plus or minus 50% and more preferably approximately plus or minus 20% of each other. Holes 310 in the frame structure are formed to receive fasteners 314 (shown in Fig. 3D). Fasteners 314 hold the upper slab 312 in place on the socket assembly and also hold the socket assembly to the circuit board. Slab 312 is preferably made of a ceramic material as is well known, thus being able to withstand the elevated temperatures. As can be seen from Fig. 3D, the upper slab 312 includes multiple holes, e.g., two rows of 12 holes each, thus enabling the socket assembly to receive a zero insertion force (ZIF), dual in-line (DIL) package. Lever 316 is used to tighten down an electronic package whose leads have been inserted into the holes in the upper slab 312, thus ensuring a good contact between the electronic package and the circuit board. In addition to the frame structure, the fasteners used in the socket assembly are also preferably made from a low thermal expansion material such as, for example, stainless steel. Preferably, the material used for the frame structure and the related fasteners are all made of the same or a similar material, to reduce thermal stresses on the assembly structure during the elevated or cyclic temperature testing.

The socket assembly as depicted in Figs 3A to 3D has several advantages for reducing the thermally induced stresses. First, the frame structure is made from a low thermal expansion coefficient material, such as stainless steel, thus experiencing a very low amount of thermal expansion during the elevated temperature testing. Since the socket assembly includes a frame and a ceramic slab connected therewith, this low coefficient of thermal expansion frame helps ensure that the frame structure does not experience excessive thermal expansions during the elevated testing, as compared with the attached ceramic slabs. Thus mis-matches between the thermal expansion of the frame structure and the slabs being supported are minimized, hence reducing the possibility of breaking the ceramic slabs.

Second, the frame structure 320 in one embodiment is a two-piece structure made by joining pieces 302 and 306. The two-piece construction provides the necessary structural support to the slab 312, while being free to allow the relative movement by thermal expansion between pieces 302 and 306, thus also reducing thermally induced stresses on the frame structure itself.

Further, as is shown on Fig. 3D, the ceramic slab 312 is preferably fastened to the frame structure on only one edge of the slab by fasteners 314. The opposite edge of the slab, parallel to and opposite the fasteners 314 is preferably not fastened to the frame structure, and thus the slab is free from the constraints requiring it to move on all four edges with the supporting frame. This method of supporting the slab by fastening it to the supporting frame along only one edge reduces the pressures on the slab in the longitudinal direction, thus also reducing the possibility of damaging or breaking the slab during elevated or cyclic temperature testing.

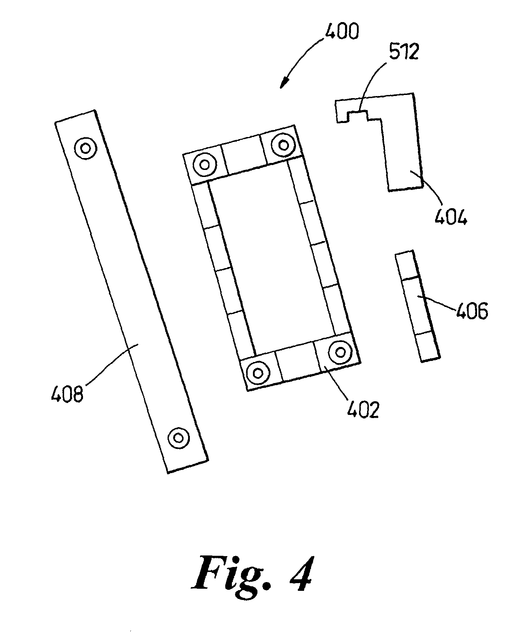

An alternate embodiment of an improved frame construction for use in a socket assembly configured to reduce the stresses on the socket (i.e. upper slab) includes portions 400 as shown in Fig. 4. Fig. 4 shows a frame structure 402, an L-shaped fastener piece 404, a push plate 406 and a stiffener 408. All portions as well as related fasteners are preferably made of a metallic material having a low coefficient of thermal expansion, such as, for example stainless steel. Other metal or non-metallic constructions are also suitable so long as the frame structure when connected with the upper slab does not create excessive thermal stresses in the socket assembly during elevated or cyclic temperature tests.

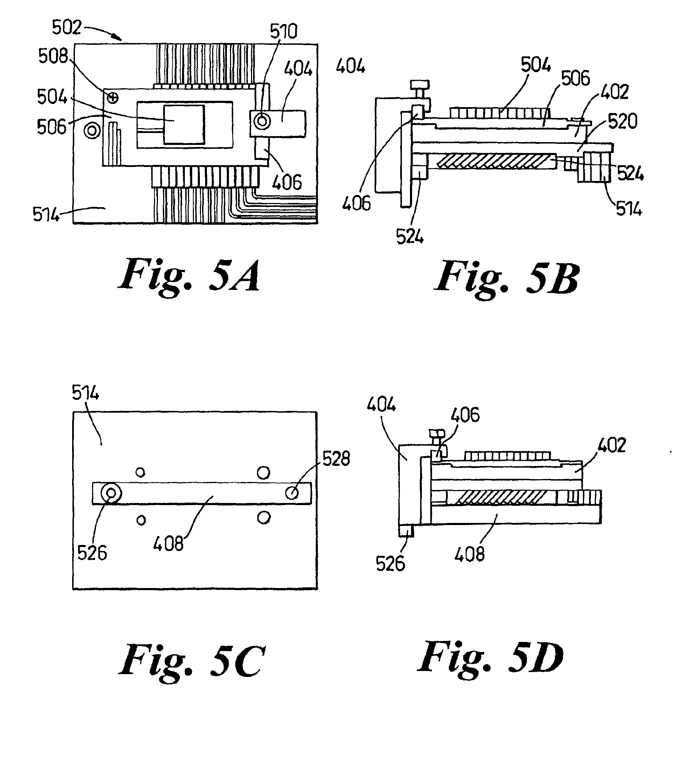

Fig. 5A shows a top view of the complete socket-frame construction 502 in accordance with this alternate embodiment of the present invention. As can be seen in Fig. 5A, an electronic package 504, such as an integrated circuit, is positioned on the upper slab 506. The slab 506 is maintained in position with respect to the frame by fasteners 508 on only one edge of the slab, and the opposite edge of the slab is preferably not fastened to the frame structure. As described above, one advantage of fastening the slab to the frame structure on only one edge is that this reduces the pressure on the slab in the longitudinal direction during elevated or cyclic temperature tests. Fig. 5A also shows a top view of the L-shaped fastener 404 engaging the push plate 406. A fastener 510 fits through a hole 512 in the L-shaped fastener, such that a turning motion of the fastener 510 will impart a downward force on the push plate ensuring a secure connection between the socket assembly and the circuit board 514.

Fig. 5B shows a side view of the socket assembly corresponding to the top view of Fig. 5A. This figures also shows the push plate 406 and the L-shaped fastener 404, that together press down to secure the socket assembly to the circuit board. As can be seen in Fig. 5B, an electronic package 504 is inserted into the upper slab 506. Upper slab 506 is supported by the frame 402. A lower slab 520 is positioned above the circuit board 514, while the distance between the lower slab and the circuit board is maintained by the spacer elements 524.

Fig. 5C is a bottom view of the socket assembly corresponding to the top view of Fig. 5A. This figure (Fig. 5C) shows the support element or stiffener piece 408 mounted to the underside of the circuit board 514. The stiffener piece is positioned underneath the socket assembly to assist in preventing the excessive bending of the circuit board due to, for example, high temperatures experienced during the elevated or cyclic temperature testing. Preventing or reducing the bending of the circuit board helps reduce excessive stresses on the socket assembly during the elevated or cyclic temperature testing. The stiffener piece 408 is held in position by two fasteners 526 and 528. Fig. 5C also shows the bottom side of the four fasteners that hold the frame structure 402 fixed with respect to the circuit board.

Fig. 5D shows another side view of the socket assembly corresponding to the top view of Fig. 5A. This figure shows a more complete socket-frame construction by also displaying the position of the stiffener 408 in relation to the overall socket assembly construction. In this embodiment, the fastener 526 (shown in Fig. 5C) is advantageously mated with the bottom side of the L-shaped fastener piece 404, thus not only attaching the L-shaped fastener to the underside of the circuit board, but also coupling the stiffener with the socket assembly construction that is above the board. This configuration helps ensure that the upper slab is pushed against the frame, while also stiffening the underneath side of the circuit board, as the upper slab is held in position with respect to the frame on only one of the upper slab's edges.

As will be understood by those of skill in the art, the present invention may be embodied in other specific forms without departing from the essential characteristics thereof. For example, frame structures may be made of any material including metallic materials that have a low coefficient of thermal expansion, such as stainless steel. Additionally, the socket assemblies described above may be adapted for use with any electronic package design including zero insertion force, and dual in line configurations regardless of the number of leads in the package. Accordingly, the foregoing is intended to be illustrative, but not limiting of the scope of invention, which is set forth in the following claims.

## Claims

1. A socket assembly for connecting an electronic package having an array of leads extending from a bottom surface thereof to a circuit board for use during testing or burn-in, comprising:
a first slab configured to be mounted above said circuit board, wherein when mounted above said circuit board said first slab is supported and maintained above said circuit board by a plurality of spacer elements, said spacer elements mounted on fasteners mountable through first apertures in said first slab;
a frame structure mounted above said first slab, said frame structure having second apertures, said second apertures configured to line up with matching first apertures on said first slab; and
a second slab mounted above said frame structure, said second slab having third apertures, where said third apertures are configured to line up with matching first apertures in said first slab, said second slab configured to be connected with said frame structure along only one edge of said second slab, thus allowing a relative movement between said second slab and said frame structure at least in a direction substantially perpendicular to said one edge,
said second slab having a plurality of pin holes to receive the leads of said electronic package, and said first slab providing for electrical connections between said electronic package and said circuit board.

2. The socket assembly of claim 1 wherein each of said first slab, said frame structure and said second slab are substantially rectangular in shape.

3. The socket assembly of claim 1 wherein said first apertures are located near the corners of said first slab, said second apertures are located near the comers of said frame structure and said third apertures are located near the comers of said second slab.

4. The socket assembly of claim 1 further comprising:
a push plate configured to be mounted above said second slab and positioned above and parallel to said one edge;
an upside down L-shaped fastener piece, said L-shaped fastener piece configured to fit over said push plate, such that one leg of said L-shaped fastener is connected with the circuit board via a fastener fitting through an aperture in said circuit board and a first aperture in said L-shaped fastener; and
a second fastener fitting through a second aperture in the other leg of said L-shaped fastener, said second fastener being configured to engage said push plate and to impart a force pushing the socket assembly towards the circuit board.

5. The socket assembly of claims 1 further comprising:
a support element configured to be mounted on the underside of the circuit board, said support element generally mounted along a longitudinal axis parallel to a longitudinal axis of said socket assembly, so as to reduce excessive thermally induced deflection of the circuit board during testing or burn-in of said electronic package.

6. The socket assembly of claim 1 wherein said frame structure comprises:
a substantially U-shaped open frame member; and
a substantially flat frame end member configured to engage said substantially U-shaped structure, so as to form a combined two-piece substantially rectangular-shaped frame structure.

7. The socket assembly of claims 1 wherein said electronic package comprises a packaged integrated circuit.

8. The socket assembly of claim 7 wherein said integrated circuit comprises a zero insertion force package.

9. The socket assembly of claim 7 wherein said integrated circuit comprises a zero insertion force dual in line package.

10. The socket assembly of claim 1 wherein said first slab and said second slab comprise ceramic slabs.

11. The socket assembly of claim 1 wherein said frame structure is a metallic structure, and wherein said metallic structure comprises a low coefficient of thermal expansion metal.

12. The socket assembly of claim 11 wherein said low coefficient of thermal expansion metal has a coefficient of thermal expansion lower than about 10.E-06 °C⁻¹.

13. The socket assembly of claim 1 wherein a percent difference between the coefficient of thermal expansion of said slabs and said frame structure is not more than 50%.

14. The socket assembly of claim 1 wherein said frame structure, said spacer elements and said fasteners are all comprised of a low coefficient of thermal expansion metal.

15. The socket assembly of claim 1 wherein said frame structure, said spacer elements and said fasteners are comprised of a stainless steel.

16. A socket assembly for connecting an electronic package having an array of leads extending from a bottom surface thereof to a circuit board for use during testing or burn-in, comprising:
a rectangular-shaped first slab configured to be mounted above said circuit board, wherein when mounted above said circuit board, said first slab is supported and maintained above said circuit board by a plurality of spacer elements, said space elements mounted on fasteners mountable through first apertures located near the corners of said first slab;
a substantially rectangular-shaped frame structure mounted above said first slab, said frame structure having second apertures located near its corners, said apertures configured to line up with matching first apertures on said first slab;
a rectangular-shaped second slab mounted above said frame structure, said second slab having third apertures located near its corners, where said third apertures are configured to line up with matching first apertures in said first slab, said second slab configured to be connected with said frame structure along only one edge of said second slab, thus allowing a relative movement between said second slab and said frame structure at least in a direction substantially perpendicular to said one edge,
said second slab having a plurality of pin holes to receive the leads of said electronic package, and said first slab providing for electrical connections between said electronic package and said circuit board; and
a push plate configured to be mounted above said second slab and positioned above and parallel to said one edge;
an upside down L-shaped fastener piece, said L-shaped fastener piece configured to fit over said push plate, such that one leg of said L-shaped fastener is connected with the circuit board via a fastener fitting through an aperture in said circuit board and a first aperture in said L-shaped fastener, and
a second fastener fitting through a second aperture in the other leg of said L-shaped fastener, said second fastener being configured to engage said push plate, to impart a force pushing the socket assembly towards the circuit board.

17. The socket assembly of claim 16 further comprising:
a support element configured to be mounted on the underside of the circuit board, said support element generally mounted along a longitudinal axis parallel to a longitudinal axis of said socket assembly, so as to reduce excessive thermally induced deflection of the circuit board during the testing or burn-in of said electronic package

18. A socket assembly for connecting an electronic package having an array of leads extending from a bottom surface thereof to a circuit board for use during testing or burn-in, comprising:
a rectangular-shaped first slab configured to be mounted above said circuit board, wherein when mounted above said circuit board said first slab is supported and maintained above said circuit board by a plurality of spacer elements, said spacer elements mounted on fasteners mountable through first apertures located near the corners of said first slab;
a substantially rectangular-shaped frame structure mounted above said first slab, said frame structure having second apertures located near its corners, said apertures configured to line up with matching first apertures on said first slab, wherein said frame structure comprises:
a substantially U-shaped open frame member; and
a substantially flat frame end member configured to engage said substantially U-shaped structure, so as to form a combined two-piece substantially rectangular shaped frame structure;
a rectangular-shaped second slab mounted above said frame structure, said second slab having third apertures located near its corners, where said apertures are configured to line up with matching first apertures in said first slab, said second slab configured to be connected with said frame structure along only one edge of said second slab, so as to allow a relative movement between said second slab and said frame structure at least in a direction substantially perpendicular to said one edge,
said second slab having a plurality of pin holes to receive the leads of said electronic package, and said first slab providing for electrical connections between said electronic package and said circuit board.
